# EUROPEAN PATENT APPLICATION

(11) **EP 3 719 576 A1**
(43) Date of publication of application: **07.10.2020**
(21) Application number: 19167248.4
(22) Date of filing: 04.04.2019
(51) Int. Cl.: G03F 7/004, G03F 7/09, G03F 7/16, G03F 7/38, G03F 7/26

(54) **RESISTLESS PATTERING MASK**

(71) Applicant: IMEC vzw, 3001 Leuven (BE); Katholieke Universiteit Leuven KU Leuven Research & Development, 3000 Leuven (BE)
(72) Inventor: KRISHTAB, Mikhail, 3001 Leuven (BE); ARMINI, Silvia, 3001 Leuven (BE)
(74) Representative: DenK iP

(57) **Abstract**

In a first aspect, the present invention relates to a method for forming a patterning mask over a layer to be patterned (100), comprising: (a) providing a carbon-based layer (200) over the layer to be patterned (100); (b) functionalizing a top surface (300) of the carbon-based layer (200) with halogen-containing groups (400); (c) partially removing the halogen-containing groups (400) by exposing pattern-wise the top surface (300) to an energy source, thereby forming a pattern comprising a first area (510) having halogen-containing groups (400) functionalizing the surface and a second area (520) without halogen-containing groups (400) functionalizing the surface; and (d) forming a metal, metal oxide or metal nitride (600) on the second area (520), selectively with respect to the first area (510).

## Description

### Technical field of the invention

The present invention relates to lithographic patterning masks and their methods of manufacture, and in particular to patterning masks which can be made without using a photoresist.

### Background of the invention

The fabrication of any semiconductor device typically involves multiple lithography steps which define the device's geometry and functionality. Alongside the continuous demand for down-scaling of semiconductor device dimensions, the wavelength of light employed in advanced optical lithography has likewise been decreasing, until eventually reaching the extreme ultraviolet (EUV) range in commercial scanners. Ongoing research for EUV lithography is directed at the development of high-power EUV light sources and the search for an optimal photoresist material.

The latter is particularly demanding as at the EUV photon energy (e.g. 92.5 eV), the mechanism of interaction between light and the photoresist material changes from a photochemical process to a radiation chemical process. In addition, further challenges that must be dealt with include stochastic effects (e.g. photon/acid shot noise), RLS (Resolution-Line width roughness-Sensitivity) trade-off, contamination of Bragg mirrors, etc. It would thus be beneficial to be able to manufacture a lithographic patterning mask without needing to use a photoresist material.

A resistless lithography method is described in US7318993, which is based on doping a pattern into a semiconductor mask layer using a selective ion implantation and subsequently wet-chemically removing the non-doped regions of the semiconductor mask layer. However, this method only allows to pattern features in the order of about 100 nm.

### Summary of the invention

It is an object of the present invention to provide methods for forming a patterning mask over a layer to be patterned. It is a further object of the present invention to provide structures and uses associated therewith. This objective is accomplished by methods and structures according to the present invention.

It is an advantage of embodiments of the present invention that a patterning mask can be formed without using a photoresist (i.e. that it can be used in a resistless lithography), thereby reducing the complexity of the patterning mask. It is a further advantage of embodiments of the present invention that the need to find an optimal photoresist material is circumvented. It is yet a further advantage that circumventing the photoresist material may lower the overall production cost of the patterning mask by reducing the development cost, material cost, processing cost, etc.

It is an advantage of embodiments of the present invention that, compared to a classical resist-based lithography, several steps can be skipped, and the resulting method is thus relatively simple and straightforward.

It is an advantage of embodiments of the present invention that in order to form the pattern of the patterning mask, only the top surface needs to be exposed to the energy source and little to no surface penetration is required; in turn allowing to lower the energy dose (e.g. the EUV dose) needed for the exposure. It is a further advantage of embodiments of the present invention that by enabling a lower energy dose to be used, the throughput of the lithography can be increased.

It is an advantage of embodiments of the present invention that the patterning mask is compatible with a wide range of underlying layers to be patterned.

It is an advantage of embodiments of the present invention that the patterning mask and its fabrication make use of materials and techniques which are commonly used in semiconductor manufacture, so that they can be easily integrated into existing processes.

It is an advantage of embodiments of the present invention that the patterning mask can be fabricated at a relatively low temperature, thereby making it compatible with materials and structures (e.g. layers to be patterned) which have a low thermal budget.

It is an advantage of embodiments of the present invention that relatively small features (e.g. with a critical dimension of about 20 nm or lower) can be defined in the patterning mask. It is an advantage of embodiments of the present invention that the patterning mask can be used in advanced lithographic patterning for the 7 nm technology node and beyond.

It is an advantage of embodiments of the present invention that an adequate to good line etch roughness can be obtained.

In a first aspect, the present invention relates to a method for forming a patterning mask over a layer to be patterned, comprising: (a) providing a carbon-based layer over the layer to be patterned; (b) functionalizing a top surface of the carbon-based layer with halogen-containing groups; (c) partially removing the halogen-containing groups by exposing pattern-wise the top surface to an energy source, thereby forming a pattern comprising a first area having halogen-containing groups functionalizing the surface and a second area without halogen-containing groups functionalizing the surface; and (d) forming a metal, a metal oxide or metal nitride on the second area, selectively with respect to the first area.

In a second aspect, the present invention relates to a method for patterning a layer, comprising performing the method according to the first aspect and further comprising a step e, after step d, of: (e) transferring the pattern into the layer to be patterned by etching through the carbon-based layer and into the layer to be patterned, selectively with respect to the metal, metal oxide or metal nitride.

In a third aspect, the present invention relates to an intermediate structure for use in a method according to any of the previous claims, comprising: (i) a layer to be patterned; and (ii) a carbon-based layer over the layer to be patterned, the carbon-based layer having a top surface functionalized with halogen-containing groups.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

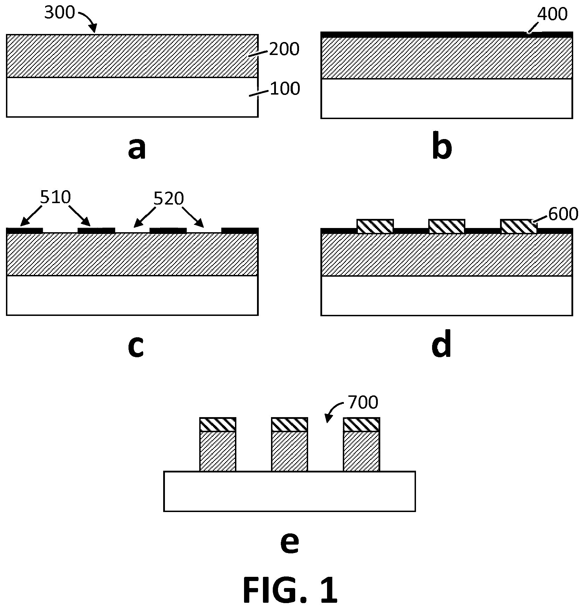

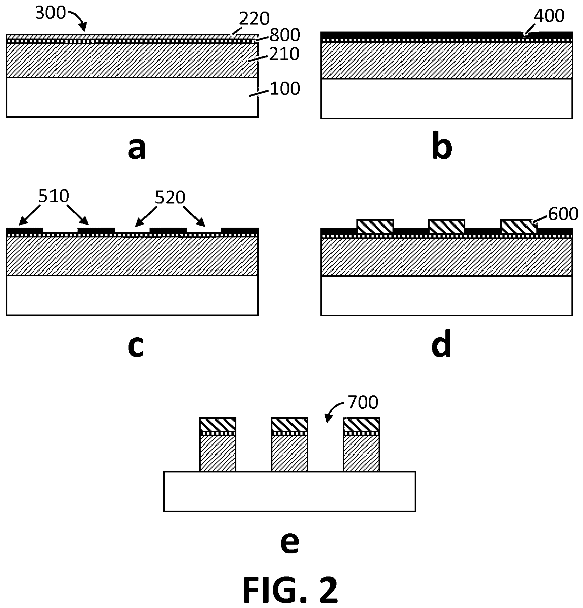

FIG 1 and 2 each schematically depict different steps in exemplary methods according to embodiments of the present invention.

In the different figures, the same reference signs refer to the same or analogous elements.

### Description of illustrative embodiments

The present invention will be described with respect to particular embodiments and with reference to certain drawings, but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, over, under and the like in the description and the claims are used for descriptive purposes and not necessarily for describing relative positions. It is to be understood that the terms so used are interchangeable with their antonyms under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those skilled in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures, and techniques have not been shown in detail in order not to obscure an understanding of this description.

The following terms are provided solely to aid in the understanding of the invention.

As used herein, and unless otherwise specified, when a first material is said to be etched selectively with respect to a second material, this means that the first material is etched faster than the second material. Preferably, the etching process would etch the first material at least twice faster, or more preferably at least five times faster, yet more preferably at least ten times faster, than the second material. In some preferred embodiments, the second material may be substantially not etched by the etching process.

As used herein, and unless otherwise specified, when a material is said to be formed (e.g. grown or deposited) area selectively on a second area with respect to a first area, this means that the material is formed faster on the second area than on the first area. Preferably, the formation of the material on the second area is at least twice faster, or more preferably at least five times faster, yet more preferably at least ten times faster, than on the first area. In some preferred embodiments, the material may be substantially not formed on the first area.

In a first aspect, the present invention relates to a method for forming a patterning mask over a layer to be patterned, comprising: (a) providing a carbon-based layer over the layer to be patterned; (b) functionalizing a top surface of the carbon-based layer with halogen-containing groups; (c) partially removing the halogen-containing groups by exposing pattern-wise the top surface to an energy source, thereby forming a pattern comprising a first area having halogen-containing groups functionalizing the surface and a second area without halogen-containing groups functionalizing the surface; and (d) forming a metal, a metal oxide or metal nitride on the second area, selectively with respect to the first area.

The second area forms a pattern corresponding to the pattern-wise exposure of the top surface. In embodiments, this pattern may comprise features which smaller lateral dimension is from 1 to 100 nm, e.g. from 2 to 20 nm.

The layer to be patterned is not particularly limited and may generally be any layer for which a sufficient etch selectivity with respect to the patterning mask can be achieved (i.e. so that the patterning mask can function as a patterning mask for the layer to be patterned). In embodiments, the layer to be patterned may be an intermediate structure in the manufacture of a semiconductor device, such as a semiconductor substrate or a semiconductor structure.

The carbon-based layer may be any organic material suitable for being functionalized with halogen-containing groups. In embodiments, it may be a halogen-free organic material. In embodiments, it may consist of carbon, hydrogen, and optionally a dopant.

In embodiments, the carbon-based layer may be an amorphous carbon layer or a polymer layer; preferably an amorphous carbon layer. Amorphous carbon layers are typically organic layers consisting of carbon, hydrogen, and optionally one or more dopants, obtained from a chemical vapor deposition of a gas mixture comprising one or more hydrocarbon compounds, one or more inert gases, optionally one or more dopants, and optionally one or more precursors of hydrogen. The amorphous carbon layer may be deposited by a variety of chemical vapor deposition methods. For instance, a plasma enhanced chemical vapor deposition may be used. For instance, a high-density plasma chemical vapor deposition may be used. The one or more dopants may be selected from nitrogen, boron, phosphorus, or mixtures thereof, among others. The one or more inert gases may be selected from argon, helium, xenon, krypton, and neon. Typically, the hydrocarbon compounds are linear hydrocarbon compounds. In one embodiment, the hydrocarbon compounds are selected from compounds having a general formula CₓH_{y}, where x has a range of between 2 and 4 and y has a range of between 2 and 10. For example, propylene (C₃H₆), propyne (C₃H₄), propane (C₃H₈), butane (C₄H₁₀), butylene (C₄H₈), butadiene (C₄H₆), or acetylene (C₂H₂) as well as combinations thereof, may be used as the hydrocarbon compound. In embodiments, the one or more precursors of hydrogen may be selected from hydrogen gas (H₂) and ammonia (NH₃), or combinations thereof, among others. Ar, He, and N₂ may be used to control the density and deposition rate of the amorphous carbon layer. The addition of H₂ and/or NH₃ can be used to control the hydrogen/carbon ratio of the amorphous carbon layer. The amorphous carbon layer can, for instance, be a PECVD amorphous carbon film of the Advanced Patterning Film™ (APF™) type. In embodiments, the carbon-based layer may have a thickness of from 2 to 200 nm.

As used herein, and unless provided otherwise, the term halogen-containing group refers to a chemical group comprising at least one halogen atom. In embodiments, halogen-containing groups may be selected from halogen atoms, halogen ions, and molecules comprising one or more halogen atoms.

In embodiments, the halogen-containing groups may contain one or more halogen atoms selected from F, Cl, Br and I. In preferred embodiments, the halogen containing groups are atoms selected from F, Cl, Br and I. These halogen atoms are bonded to carbon. For the halogen-containing groups, a trade-off between good bonding stability and good sensitivity to the energy source is often desired. For the halogen series F, Cl, Br, and I, it is often observed that the halogen atom providing the highest sensitivity is not the same as the halogen atom providing the highest stability. For instance, the sensitivity to EUV may increase in the following order Cl<Br<F<I while the thermal stability more typically follows the following order I<Br<Cl<F. At least for F and Cl, the halogen-containing group's bonding is typically stable enough to advantageously allow intermediate structures to be moved freely (i.e. in ambient atmosphere) from a first processing tool (e.g. a plasma chamber) to a second processing tool (e.g. a EUV system) with little to no degradation thereof.

In embodiments, step b may comprise a plasma treatment.

In embodiments, the process conditions used in step b may be selected such as to optimize the following goals: maximize the lateral concentration of the halogen functional groups (e.g. high and uniform halogen functionalization at the top surface with minimal surface penetration thereof), minimize the formation of defect sites and/or contaminating groups, and minimize the etching of the carbon-based material (e.g. during a plasma treatment). Optimizing the process conditions in this way typically has a positive influence on the obtained line width roughness of the eventual patterning mask.

In some embodiments, step b may comprise chemically (e.g. covalently or ionically) bonding the halogen-containing groups (i.e. the halogen atoms or ions as such or molecules comprising the halogen atom(s) such as e.g. halocarbons) directly to the carbon-based layer. Such a chemical bonding advantageously provides a stable and well-defined attachment of the halogen-containing groups. Step b may, for example, comprise exposing the carbon-based layer to a halogen-based plasma (e.g. Cl₂ or CF₄). This typically yields halogenation of only the first few monolayers (e.g. 10 nm deep or less) of the carbon-based layer, in a reaction which is furthermore self-limiting in nature. In embodiments, it is advantageous for this halogenation to be limited to the top surface, without penetrating into the carbon-based layer (or with a penetration limited to maximum 10 nm), as in that case also the energy source will only need to act on the surface, in turn allowing the energy dose to be relatively low.

In embodiments, step b may result in only the top surface of the carbon-based layer being functionalized.

In embodiments, step b may result in a top portion of the carbon-based layer being functionalized, said top portion comprising the top surface and having a thickness of 10 nm or less, preferably 5 nm, yet more preferably 2 nm.

. Although the present invention also works when a thicker portion of the carbon-based layer is functionalized, deeper functionalization has no particular advantages and requires a higher energy budget during step b and/or c.

In embodiments, step b results in a uniform functionalization of the top surface.

In embodiments, step b may comprise adsorbing the halogen-containing groups (e.g. molecule comprising halogen atoms) onto the carbon-based layer. This can advantageously be easily achieved using a wet deposition method (e.g. spin coating). However, this may yield a less stable attachment of the halogen-containing groups (e.g. because the adsorbed molecules may more easily migrate over the surface as compared to a chemical attachment) and may require the time between patterning the halogen-containing groups (i.e. step c) and patterning the layer to be patterned (i.e. step e) to be kept relatively short. Step b may, for example, comprise providing a self-assembled monolayer (SAM) over the top surface, the self-assembled monolayer comprising the halogen-containing groups. Typically, the self-assembled monolayer further comprises a functional group for adsorbing or attaching to the carbon-based layer.

The energy source is typically such that it can break (e.g. by radiolysis) the halogen's bond (e.g. a C-X bond, where X is the halogen and C is a carbon atom to which it is attached) in a targeted fashion; such an energy source may be referred to as a 'high-energy source'. In embodiments, the energy source may be selected from extreme ultraviolet (EUV) irradiation, X-ray irradiation, e-beam irradiation, and ion beam irradiation; preferably EUV irradiation. Alternatively, the energy source may be coupled to a scanning probe lithography (e.g. using atomic force microscopy, AFM, or scanning tunneling microscopy, STM), such as a thermal or electric field scanning probe lithography.

The halogen's bond (e.g. C-X) is typically more sensitive to breaking under influence of the energy source than other bonds commonly occurring in the carbon-based material (e.g. C-C bonds), so that the halogen-based functionalization advantageously permits to reduce the required energy dose. This dose is preferably selected such that the concentration of halogen atoms in the targeted area is reduced by at least 30%, preferably at least 50%, yet more preferably at least 90%. Such a reduction advantageously allows a good area selective formation of the metal, metal oxide or metal nitride in step d.

The area selective formation is typically an area selective deposition in the case of a metal and an area selective deposition or growth in the case of a metal oxide or a metal nitride.

Without being bound by theory, the area selective formation in step d is believed to be typically achieved by a difference in nucleation rate of a precursor of the metal, metal oxide or metal nitride between the first and second area. As such, forming the metal, metal oxide or metal nitride in step d may preferably comprise using at least one precursor (and preferably only precursors) which results in poor nucleation on the second surface (e.g. at least two times slower, preferably at least five times slower, yet more preferably at least ten times slower; as compared to the first surface). In embodiments, such a precursor may be a halide precursor (e.g. TiCl₄ or TiI₄) or a precursor which adsorbs preferentially on a hydrophilic surface.

In embodiments, step d may comprise an atomic layer deposition (ALD), a molecular layer deposition (MLD) or a chemical vapour deposition (CVD); preferably atomic layer deposition. In embodiments, step d may comprise a cyclical deposition process (e.g. multiple ALD cycles). In embodiments, step d may comprise one or more deposition steps alternated with one or more defect etching steps. Such a defect etching step can, for example, entail reducing (or completely removing) undesired nucleation sites (i.e. nucleation sites on the first area) before continuing the deposition process to expand the remaining nucleation sites. Such an alternation of formation and defect etching steps can advantageously positively affect the achieved area selectivity of the metal, metal oxide or metal nitride formation.

In embodiments, the metal, metal oxide or metal nitride selectively formed in step d may function as a patterned hardmask layer. In embodiments, the metal may be ruthenium, the metal oxide may be a titanium oxide and the metal nitride may be a titanium nitride. In embodiments, the formed metal, metal oxide and/or metal nitride may have a thickness of at least 2 nm, preferably at least 3 nm, such as from 3 to 10 nm. The etch selectivity that can be achieved between metal, metal oxide or metal nitride and the carbon-based material is typically high, such that even such a relatively thin layer of the metal, metal oxide or metal nitride can be sufficient to achieve a good pattern transfer. A lower formation temperature (cf. next paragraph) in step d typically also has a positive influence on the obtained line width roughness of the eventual patterning mask.

In embodiments, at least steps c and d (and preferably the whole method), except if a thermal energy source is used in step c, are performed at a temperature below 300 °C, preferably below 250 °C, yet more preferably below 200 °C. The thermal decomposition temperature of a C-X bond is typically around 250 to 300 °C, so the method steps are advantageously performed below this temperature so as to avoid undesired dehalogenation (unless it is purposely done in a targeted fashion in step c, e.g. using a thermal scanning probe lithography).

In embodiments, step a may comprise: (a1) providing a first carbon-based layer over the layer to be patterned, (a2) providing a sensitizing layer over the first carbon-based layer, and (a3) providing a second carbon-based layer over the sensitizing layer. In embodiments, the sensitizing layer may have a thickness of from 1 to 5 nm. The sensitizing layer is typically a layer which makes the structure (e.g. the functionalizing halogen-containing groups) more susceptible to the energy source (e.g. increasing the EUV or X-ray absorption). This advantageously allows to further reduce the dose of the energy source. In embodiments, the sensitizing layer may be a EUV sensitizing layer. In embodiments, the sensitizing layer may be a metal-containing layer. In embodiments, the metal-containing layer may comprise a metal, a metal nitride, a metal oxide, a metal halide, a metal telluride, or a metal antimonide, wherein the metal element is selected from Zn, Ti, Hf, Zr, Ru, Ni, Co, Mo, Sn, and In. For instance, the metal-containing layer may be TiOₓ, TiN, Ti, NiOₓ, SnOₓ or InOₓ. In embodiments, the second carbon-based layer may have a thickness of from 2 to 20 nm, preferably from 2 to 10 nm.

In embodiments, the method may further comprise a step, after step d, of: transferring the pattern into the carbon-based layer by etching the carbon-based layer and into the layer to be patterned, selectively with respect to the metal, metal oxide or metal nitride. The carbon-based layer may hereby be patterned completely, so as to expose the layer to be patterned underneath.

In a second aspect, the present invention relates to a method for patterning a layer, comprising performing the method according to any of the embodiments of the first aspect and further comprising a step e, after step d, of: (e) transferring the pattern into the layer to be patterned by etching through the carbon-based layer and into the layer to be patterned, selectively with respect to the metal, metal oxide or metal nitride.

In embodiments, any feature of any embodiment of the second aspect may independently be as correspondingly described for any embodiment of any of the other aspects.

In a third aspect, the present invention relates to an intermediate structure for use in a method according to any embodiment of the first or second aspect, comprising: (i) a layer to be patterned; and (ii) a carbon-based layer over the layer to be patterned, the carbon-based layer having a top surface functionalized with halogen-containing groups.

In embodiments, the top surface may be uniformly covered with halogen-containing groups. Such an intermediate structure may be as obtained after step b and before step c in a method according to the first aspect.

In embodiments, the top surface may be patterned, the pattern comprising a first area having halogen-containing groups functionalizing the surface and a second area without halogen-containing groups functionalizing the surface. Such an intermediate structure may be as obtained after step c in a method according to the first aspect.

In embodiments, the method may further comprise a metal, metal oxide or metal nitride covering the second area, selectively with respect to the first area. Such an intermediate structure may be as obtained after step d in a method according to the first aspect.

In embodiments, the halogen-containing groups may be limited to a depth of 10 nm, preferably 5 nm, yet more preferably 2 nm, from the top surface.

In embodiments, the carbon-based layer may comprise: (iia) a first carbon-based layer, (iib) a sensitizing layer (typically a metal-containing layer) over the first carbon-based layer, and (iic) a second carbon-based layer over the sensitizing layer, comprising the top surface functionalized with halogen-containing groups.

In embodiments, any feature of any embodiment of the third aspect may independently be as correspondingly described for any embodiment of any of the other aspects.

The invention will now be described by a detailed description of several embodiments of the invention. It is clear that other embodiments of the invention can be configured according to the knowledge of the person skilled in the art without departing from the true technical teaching of the invention, the invention being limited only by the terms of the appended claims.

### Example 1: Fabrication of a patterning mask

We now refer to FIG 1a. A 10-200 nm thick amorphous carbon layer (200) in first deposited on top of a layer to be patterned (100).

We now refer to FIG 1b. Halogen-containing groups (here halogen atoms) (400) are subsequently grafted onto the top surface (300) of the amorphous carbon layer (200), for example by a short exposure (e.g. 2-60 s) of the amorphous carbon layer (200) to a halogen-based plasma (e.g. Cl₂ or CF₄).

We now refer to FIG 1c. The top surface (300) is subsequently patterned by removing halogen-containing groups (400) in specific pre-defined areas through exposure to an energy source (e.g. EUV, e-beam, X-ray or ion beam); thereby obtaining a first area (510) having halogen-containing groups functionalizing the surface and a second area (520) without halogen-containing groups. For example, a pattern can be written with a 2-50 keV e-beam (corresponding to a dose of 100-10000 µC/cm²), or by a local irradiation with 13.5 nm EUV (corresponding to a dose of 10-1000 mJ/cm²).

We now refer to FIG 1d. A metal, metal oxide or metal nitride hard-mask layer (600) is area-selectively deposited on the exposed parts of the amorphous carbon layer (200) (i.e. the second area 520), with respect to the halogen-functionalized parts (i.e. the first area 510), using an atomic layer deposition (ALD), molecular layer deposition (MLD) or chemical vapour deposition (CVD) process. This can, for example, entail the deposition of a 2-10 nm thick TiO₂ layer (600) by thermal ALD (e.g. at 50-250 °C) from TiCl₄ and H₂O as precursors.

We now refer to FIG 1e. The pattern is transferred into (700) the amorphous carbon layer (200), e.g. by an anisotropic dry etching of the amorphous carbon layer (200) using an N₂/H₂, O₂/CO₂ or He/H₂ based plasma which is selective to the amorphous carbon (200) with respect to the metal, metal oxide or metal nitride (600).

The obtained structure can then be used (not depicted) as a patterning mask for the underlying layer to be patterned (100).

### Example 2: Fabrication of a patterning mask using a sensitizing layer

Example 1 is repeated but a sensitizing layer is used in the fabrication method.

We now refer to FIG 2. A 10-200 nm thick carbon-based layer in first formed on top of a layer to be patterned (100). The carbon-based layer comprises a first amorphous carbon layer (210), a 1-5 nm thick sensitizing layer (800) deposited on the first amorphous carbon layer (210) and a second amorphous carbon layer (220) deposited on the sensitizing layer (800). The second amorphous carbon layer (220) may, for example, have a thickness of about 2 nm, so that the sensitizing layer (800) is relatively close to the top surface. The sensitizing layer (800) can, for instance, be a EUV sensitizing layer (800) (e.g. a metal-containing layer, such as TiOₓ, TiN, Ti, NiOₓ, SnOₓ or InOₓ) which promotes EUV absorption and makes the second amorphous carbon layer (220) more susceptible to said EUV absorption.

We now refer to FIG 2b. Halogen-containing groups (400) are subsequently grafted onto the top surface of the second amorphous carbon layer (220), for example by a short exposure (e.g. 2-60 s) of the second amorphous carbon layer (220) to a halogen-based plasma (e.g. Cl₂ or CF₄).

We now refer to FIG 2c. The top surface (300) is subsequently patterned by removing halogen-containing groups (400) in specific pre-defined areas through exposure to an energy source (e.g. EUV, e-beam, X-ray or ion beam); thereby obtaining a first area (510) having halogen-containing groups functionalizing the surface and a second area (520) without halogen-containing groups. For example, a pattern can be written with a 2-50 keV e-beam (corresponding to a dose of 100-10000 µC/cm²), or by a local irradiation with 13.5 nm EUV (corresponding to a dose of 10-1000 mJ/cm²).

We now refer to FIG 2d. A metal, metal oxide or metal nitride hard-mask layer (600) is area-selectively deposited on the exposed parts of the second amorphous carbon layer (220) (i.e. the second area 520), with respect to the halogen-functionalized parts (i.e. the first area 510), using an atomic layer deposition (ALD), molecular layer deposition (MLD) or chemical vapour deposition (CVD) process. This can for example entail the deposition of a 2-10 nm thick TiO₂ layer (600) by thermal ALD (e.g. at 50-250 °C) from TiCl₄ and H₂O as precursors.

We now refer to FIG 2e. The pattern is transferred into (700) the amorphous carbon layer (200), e.g. by an anisotropic dry etching of the amorphous carbon layer (200) using an N₂/H₂, O₂/CO₂ or He/H₂ based plasma which is selective to the amorphous carbon with respect to the metal, metal oxide or metal nitride (600).

The obtained structure can then be used (not depicted) as a patterning mask for the underlying layer to be patterned (100).

It is to be understood that although preferred embodiments, specific constructions, and configurations, as well as materials, have been discussed herein for devices according to the present invention, various changes or modifications in form and detail may be made without departing from the scope and technical teachings of this invention. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. A method for forming a patterning mask over a layer to be patterned (100), comprising:
a. providing a carbon-based layer (200) over the layer to be patterned (100);
b. functionalizing a top surface (300) of the carbon-based layer (200) with halogen-containing groups (400);
c. partially removing the halogen-containing groups (400) by exposing pattern-wise the top surface (300) to an energy source, thereby forming a pattern comprising a first area (510) having halogen-containing groups (400) functionalizing the surface and a second area (520) without halogen-containing groups (400) functionalizing the surface; and
d. forming a metal, metal oxide or metal nitride (600) on the second area (520), selectively with respect to the first area (510).

2. The method according to claim 1, wherein the carbon-based layer (200) comprises an amorphous carbon layer (200).

3. The method according to any of the previous claims, wherein step b comprises a plasma treatment.

4. The method according to any of the previous claims, wherein the halogen-containing groups (400) are one or more atoms selected from F, CI, Br and I.

5. The method according to any of the previous claims, wherein the energy source is selected from extreme ultraviolet irradiation, X-ray irradiation, e-beam irradiation, and ion beam irradiation.

6. The method according to any of the previous claims, wherein step d comprises an atomic layer deposition, a molecular layer deposition or a chemical vapour deposition.

7. The method according to any of the previous claims, wherein the metal is a ruthenium, the metal oxide is a titanium oxide, and the metal nitride is a titanium nitride.

8. The method according to any of the previous claims, wherein step a comprises:
a1. providing a first carbon-based layer (210) over the layer to be patterned (100),
a2. providing a sensitizing layer (800) over the first carbon-based layer (210), and
a3. providing a second carbon-based layer (220) over the sensitizing layer (800).

9. A method for patterning a layer (100), comprising performing the method according to any of the previous claims and further comprising a step e, after step d, of:
e. transferring the pattern into the layer to be patterned (100) by etching through the carbon-based layer (200) and into the layer to be patterned (100), selectively with respect to the metal, metal oxide or metal nitride (600).

10. An intermediate structure for use in a method according to any of the previous claims, comprising:
i. a layer to be patterned (100); and
ii. a carbon-based layer (200) over the layerto be patterned (100), the carbon-based layer (200) having a top surface (300) functionalized with halogen-containing groups (400).

11. The intermediate structure according to claim 10, wherein the top surface (300) is uniformly covered with halogen-containing groups (400).

12. The intermediate structure according to claim 10, wherein the top surface (300) is patterned, the pattern comprising a first area (510) having halogen-containing groups (400) functionalizing the surface and a second area (520) without halogen-containing groups (400) functionalizing the surface.

13. The intermediate structure according to claim 12, further comprising a metal, metal oxide or metal nitride (600) covering the second area (520), selectively with respect to the first area (510).

14. The intermediate structure according to any of claims 10 to 13, wherein the halogen-containing groups (400) are limited to a depth of 10 nm, preferably 5 nm, yet more preferably 2 nm, from the top surface (300).

15. The intermediate structure according to any of claims 10 to 14, wherein the carbon-based layer (200) comprises:
iia. a first carbon-based layer (210),
iib. a metal-containing layer (800) over the first carbon-based layer (210), and
iic. a second carbon-based layer (220) over the metal-containing layer (800), comprising the top surface (300) functionalized with halogen-containing groups (400).
